# FASCICULE DE BREVET EUROPEEN

(11) **EP 2 706 582 B1**
(45) Date de publication et mention de la délivrance du brevet: **08.04.2015**
(21) Numéro de dépôt: 13183707.2
(22) Date de dépôt: 10.09.2013
(51) Int. Cl.: H01L 45/00

(54) **Cellule mémoire à changement de phase**
Phasenwechselspeicherzelle
Phase-change memory cell

(30) Priorité: 10.09.2012 FR 1258471
(43) Date de publication de la demande: 12.03.2014
(73) Titulaire: STMicroelectronics (Crolles 2) SAS, 38920 Crolles (FR); COMMISSARIAT A L'ENERGIE ATOMIQUE ET AUX ENERGIES ALTERNATIVES, 75015 Paris (FR)
(72) Inventeur: Nodin, Jean-François, 38950 Quaix en Chartreuse (FR); Sousa, Véronique, 38000 Grenoble (FR); Lhostis, Sandrine, 38570 Theys (FR)
(74) Mandataire: Thibon, Laurent

(56) Documents cités:
- DE-A1-102010 061 572
- US-A1- 2006 166 471
- US-A1- 2010 283 029
- US-A1- 2011 049 456

## Description

### Domaine de l'invention

La présente invention concerne une cellule mémoire à changement de phase couramment appelée dans la technique cellule PCRAM ("Phase-Change Random Access Memory" - mémoire vive à changement de phase). La présente invention concerne également un procédé de fabrication de telles cellules PCRAM.

### Exposé de l'art antérieur

Les mémoires PCRAM utilisent des matériaux dits à changement de phase qui sont capables de passer d'une phase cristalline à une phase amorphe, et inversement, la phase cristalline étant conductrice et la phase amorphe peu conductrice. Ces matériaux à changement de phase sont par exemple des chalcogénures. Les conductivités de la phase cristalline et de la phase amorphe de tels matériaux peuvent être dans un rapport élevé, de 10³ à 10⁶.

Un inconvénient des structures existantes de mémoires PCRAM réside dans leur consommation élevée.

US 2010/0283029 décrit une cellule mémoire comprenant un via en un matériau à changement de phase disposé entre une électrode inférieure et une électrode supérieure, le via comprenant une région centrale et une région périphérique, la température de cristallisation de la région centrale étant inférieure à celle de la région périphérique.

### Résumé

Ainsi, un objet d'un mode de réalisation de la présente invention est de prévoir une cellule PCRAM présentant des performances améliorées.

Un objet d'un mode de réalisation de la présente invention est de prévoir une cellule PCRAM présentant une consommation réduite.

Un mode de réalisation de la présente invention prévoit une cellule mémoire comprenant un via en un matériau à changement de phase disposé entre une électrode inférieure et une électrode supérieure, dans laquelle le via comprend une région centrale entourée latéralement par une région périphé- rique, chacune des régions central et périphérique s'étendant sure toute la hauteur du via, les températures de cristallisation et de fusion de la région centrale étant respectivement inférieures à celles de la région périphérique.

Selon un mode de réalisation de la présente invention, le via en matériau à changement de phase a une hauteur comprise entre 30 et 100 nm et des dimensions latérales comprises entre 100 et 300 nm, et la région centrale du via a des dimensions latérales comprises entre 20 et 90 nm.

Selon un mode de réalisation de la présente invention, la région centrale du via en matériau à changement de phase comprend des espèces implantées.

Selon un mode de réalisation de la présente invention, la région périphérique du via en matériau à changement de phase comprend des espèces implantées.

Selon un mode de réalisation de la présente invention, le matériau à changement de phase est en tellurure de germanium et les espèces implantées sont de l'étain et de l'antimoine.

Selon un mode de réalisation de la présente invention, le matériau à changement de phase est en tellurure de germanium et les espèces implantées sont du silicium.

Selon un mode de réalisation de la présente invention, le matériau à changement de phase est en tellurure d'antimoine et les espèces implantées sont du tellure.

Selon un mode de réalisation de la présente invention, le via en matériau à changement de phase est entouré latéra- lement par un matériau isolant.

Selon un mode de réalisation de la présente invention, une première couche barrière est interposée entre l'électrode inférieure et le matériau à changement de phase, et une seconde couche barrière est interposée entre l'électrode supérieure et le matériau à changement de phase.

Un mode de réalisation de la présente invention prévoit en outre un procédé de fabrication d'une cellule mémoire, comprenant les étapes consistant à former une ouverture dans une couche isolante recouvrant une première électrode formée sur un substrat ; remplir l'ouverture d'un matériau à changement de phase pour former un via ; implanter des espèces seulement dans une région centrale du via en matériau à changement de phase pour que les températures de cristallisation et de fusion de cette région centrale soient inférieures respectivement à celles d'une région périphérique du via entourant la région centrale ; et recouvrir le via d'une seconde électrode.

Un mode de réalisation de la présente invention prévoit en outre un procédé de fabrication d'une cellule mémoire, comprenant les étapes consistant à former une ouverture dans une couche isolante recouvrant une première électrode formée sur un substrat ; remplir l'ouverture d'un matériau à changement de phase pour former un via ; implanter des espèces seulement dans une région périphérique du via en matériau à changement de phase pour que les températures de cristallisation et de fusion de cette région périphérique soient supérieures respectivement à celles d'une région centrale du via entourée par la région périphérique ; et recouvrir le via d'une seconde électrode.

### Brève description des dessins

Ces caractéristiques et avantages, ainsi que d'autres seront exposés en détail dans la description suivante de modes de réalisation particuliers faite à titre non limitatif en relation avec les figures jointes parmi lesquelles :
la figure 1 est une vue en coupe représentant de façon schématique un exemple de cellule PCRAM ;
la figure 2 est une vue en coupe représentant de façon schématique une cellule PCRAM confinée ;
la figure 3 est une vue en coupe représentant de façon schématique une cellule PCRAM confinée présentant des performances accrues ;
la figure 4 est une vue en coupe représentant de façon schématique une variante de la cellule PCRAM confinée de la figure 3 ; et
les figures 5A à 5E sont des vues en coupe illustrant de façon schématique des étapes successives d'un procédé de fabrication de la cellule PCRAM confinée de la figure 3.

Par souci de clarté, de mêmes éléments ont été désignés par de mêmes références dans les différentes figures et, de plus, comme cela est habituel dans la représentation des composants microélectroniques, les diverses figures ne sont pas tracées à l'échelle.

### Description détaillée

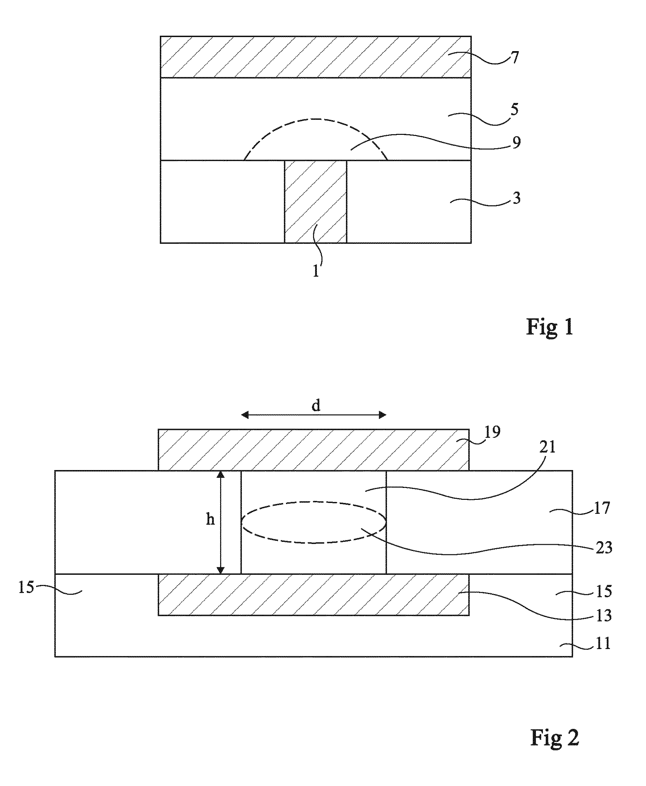

La figure 1 est une vue en coupe représentant de façon schématique un exemple classique de cellule PCRAM.

Sur un substrat non représenté repose une électrode 1 entourée d'un matériau isolant 3. Un matériau à changement de phase 5 recouvre l'électrode 1 et le matériau isolant 3. Le matériau à changement de phase 5 est recouvert d'une électrode 7. Les électrodes 1 et 7 sont de dimensions différentes, l'électrode 1 étant plus étroite que l'électrode 7.

Le fonctionnement d'une telle cellule PCRAM est le suivant.

On considère un état initial dans lequel le matériau à changement de phase 5 est cristallin (conducteur).

Pour passer de cet état conducteur à un état résistif, une impulsion brève de tension élevée est appliquée entre les deux électrodes 1 et 7. Ceci entraîne un échauffement par effet Joule du matériau à changement de phase 5. Le matériau à changement de phase 5 atteint sa température de fusion dans une région 9, délimitée par des pointillés, proche de la plus petite électrode 1. La région 9 du matériau à changement de phase 5 fond puis se refroidit à l'état amorphe (résistif).

Pour passer de l'état résistif à l'état conducteur, une impulsion longue de tension faible est appliquée entre les deux électrodes 1 et 7. Ceci entraîne un échauffement par effet Joule du matériau à changement de phase 5, qui atteint sa température de cristallisation dans la région 9. La région 9 du matériau à changement de phase 5 cristallise et redevient conductrice.

De telles cellules PCRAM présentent des problèmes de fiabilité et de rétention. De nouvelles structures de cellules PCRAM ont donc été proposées.

La figure 2 est une vue en coupe représentant de façon schématique un exemple de cellule PCRAM dite confinée.

Sur un substrat non représenté repose une couche isolante 11 revêtue d'une couche conductrice 13 entourée d'un matériau isolant 15. La couche conductrice 13 et le matériau isolant 15 sont recouverts d'une couche isolante 17 elle-même recouverte d'une couche conductrice 19. Un via 21 en un matériau à changement de phase traverse la couche isolante 17 et s'étend de la couche conductrice 19 à la couche conductrice 13.

Les couches conductrices 13 et 19 constituent respectivement les électrodes inférieure et supérieure de la cellule PCRAM. Le via 21 en matériau à changement de phase constitue la zone active de la cellule. Dans une telle cellule PCRAM, les électrodes 13 et 19 sont de même dimension.

Le fonctionnement de cette cellule PCRAM confinée est similaire à celui de la cellule PCRAM illustrée en figure 1, hormis le fait que, si les électrodes 13 et 19 sont de même dimension, la région du matériau à changement de phase 21 qui passe de la phase cristalline à la phase amorphe et inversement, délimitée par des pointillés et désignée par la référence 23, est située sensiblement à égale distance des électrodes 13 et 19. En outre, la région 23 s'étend sur toute la section horizontale du via 21.

Pour réduire la consommation d'une cellule PCRAM confinée du type de celle illustrée en figure 2, il est souhaitable de réduire le diamètre d du via 21 en matériau à changement de phase.

Pour réaliser le via 21, une ouverture est formée dans la couche isolante 17 puis remplie de matériau à changement de phase. Les matériaux à changement de phase, notamment les chalcogénures, sont généralement déposés par pulvérisation. Contrairement aux procédés CVD ("Chemical Vapor Deposition" - Dépôt chimique en phase vapeur), il est difficile, dans le cas de dépôts par pulvérisation et plus généralement de dépôts PVD ("Physical Vapor Deposition" - Dépôt physique en phase vapeur), de remplir des ouvertures de facteur de forme supérieur à 1, le facteur de forme correspondant au rapport de la hauteur h sur le diamètre d de l'ouverture.

Par ailleurs, dans une cellule PCRAM confinée du type de celle illustrée en figure 2, la région 23 du matériau à changement de phase 21 qui change d'état a une section verticale de forme elliptique. Ceci est dû au fait que les pertes thermiques sont plus importantes au contact avec les électrodes 13 et 19 conductrices thermiques qu'au contact avec le matériau isolant thermique 17. Il en résulte une augmentation de la consommation de la cellule PCRAM confinée.

Pour réduire le diamètre effectif du via en matériau à changement de phase d'une cellule PCRAM confinée tout en conservant un facteur de forme faible de l'ouverture préalablement formée, les inventeurs proposent de former un via de grand diamètre puis de rendre inactive la région périphérique du via. Pour cela, des espèces sont implantées dans le matériau à changement de phase, soit dans sa région centrale, soit dans sa région périphérique, pour que les températures de cristallisation et de fusion de la région périphérique du via soient supérieures à celles de la région centrale du via. Ainsi, il est possible de modifier l'état de la région centrale sans affecter la région périphérique.

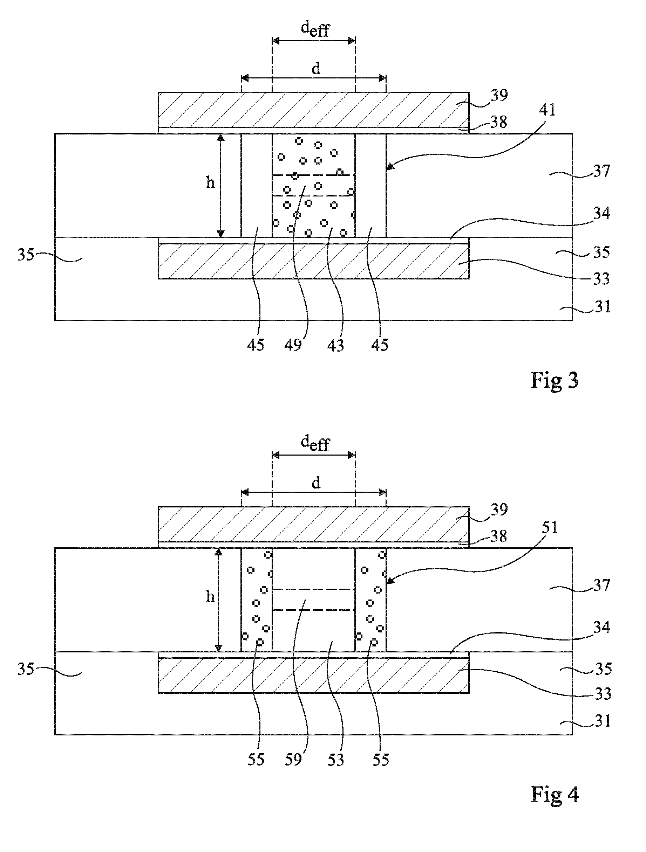

La figure 3 est une vue en coupe représentant de façon schématique une cellule PCRAM confinée dont le via en matériau à changement de phase présente un diamètre effectif réduit.

Sur un substrat non représenté, par exemple en silicium, repose une couche isolante 31 revêtue d'une couche conductrice 33 entourée d'un matériau isolant 35. La couche conductrice 33 et le matériau isolant 35 sont recouverts d'une couche isolante 37 elle-même recouverte d'une couche conductrice 39. Un via 41 en un matériau à changement de phase traverse la couche isolante 37 et s'étend de la couche conductrice 39 à la couche conductrice 33. Les couches conductrices 33 et 39 constituent respectivement les électrodes inférieure et supérieure de la cellule PCRAM. Le via 41 a par exemple une section circulaire, carrée ou rectangulaire.

Avantageusement, des couches barrière 34 et 38 sont interposées respectivement entre la couche conductrice 33 et la couche isolante 37 et entre la couche conductrice 39 et la couche isolante 37. Les couches barrière 34 et 38 sont destinées à empêcher la diffusion de métaux des électrodes 33 et 39 vers le matériau à changement de phase 41 et la couche isolante 37.

Les électrodes 33 et 39 sont par exemple en siliciure d'aluminium (AlSi) et ont par exemple une épaisseur comprise entre 50 et 500 nm. Les couches barrière sont par exemple en nitrure de titane (TiN) et ont par exemple une épaisseur comprise entre 5 et 50 nm. Les couches isolantes 31, 35 et 37 sont par exemple en oxyde de silicium.

Le via 41 en matériau à changement de phase comprend une région centrale 43 entourée par une région périphérique 45. Des espèces ont été implantées dans la région centrale 43 du via 41 de sorte que les températures de cristallisation et de fusion de la région centrale 43 soit inférieures à celles de la région périphérique 45.

La zone active d'une telle cellule PCRAM confinée correspond à la région centrale 43 du via 41 en matériau à changement de phase, de diamètre d_{eff} inférieur au diamètre d du via 41.

L'épaisseur de la couche isolante 37, et donc la hauteur h du via 41, est par exemple comprise entre 30 et 100 nm, par exemple de l'ordre de 50 nm. Les dimensions latérales d du via 41 (le diamètre d du via 41 dans le cas où le via a une section circulaire) sont par exemple comprises entre 100 et 300 nm, par exemple de l'ordre de 150 nm. La région centrale 43 du via 41 a par exemple des dimensions latérales d_{eff} comprises entre 20 et 90 nm.

Selon un exemple de réalisation, le matériau à changement de phase 41 est en tellurure de germanium (Ge_{0,3}Te_{0,7}) et la région centrale 43 du matériau 41 comprend de l'antimoniure d'étain (SnSb). Les températures de cristallisation et de fusion de la région périphérique 45 en Ge_{0,3}Te_{0,7} sont respectivement d'environ 250°C et d'environ 600°C, tandis que les températures de cristallisation et de fusion de la région centrale 43 ayant reçu une implantation de Sn et de Sb sont respectivement d'environ 140°C et d'environ 475°C.

Dans une telle cellule PCRAM confinée, la région du matériau à changement de phase 41 qui passe de la phase cristalline à la phase amorphe et inversement, délimitée par des pointillés et désignée par la référence 49, est située sensiblement à égale distance des électrodes 33 et 39 et s'étend seulement sur la section de diamètre d_{eff} de la région centrale 43 du via 41. La région périphérique 45 du via 41 reste amorphe.

Le fonctionnement d'une cellule PCRAM confinée du type de celle illustrée en figure 3 est le suivant.

On considère un état initial dans lequel la région centrale 43 du via 41 en matériau à changement de phase est cristalline (conductrice) et la région périphérique 45 du via 41 est amorphe (résistive).

Pour passer de cet état conducteur à un état résistif, une impulsion brève de tension élevée est appliquée entre les deux électrodes 33 et 39, de sorte que la région centrale 43 du via 41 ayant reçu une implantation d'espèces atteigne sa température de fusion, mais pas la région périphérique 45 qui a une température de fusion plus élevée. La région 49 de la région centrale 43 du via 41 fond puis se refroidit à l'état amorphe (résistif).

Pour passer de l'état résistif à l'état conducteur, une impulsion longue de tension faible est appliquée entre les deux électrodes 33 et 39, de sorte que la région centrale 43 du via 41 ayant reçu une implantation d'espèces atteigne sa température de cristallisation, mais pas la région périphérique 45 qui a une température de cristallisation plus élevée. La région 49 de la région centrale 43 du via 41 cristallise et redevient conductrice.

Un avantage d'une cellule PCRAM confinée du type de celle illustrée en figure 3 réside dans le fait que le diamètre effectif du via en matériau à changement de phase est réduit d'où il résulte des performances accrues de la cellule PCRAM.

Un autre avantage d'une cellule PCRAM confinée du type de celle illustrée en figure 3 réside dans le fait qu'elle peut être fabriquée facilement. Comme le facteur de forme h/d de l'ouverture formée dans la couche isolante 37 pour réaliser le via 41 est faible, par exemple inférieur ou égal à 1, l'ouverture peut être remplie facilement d'un matériau à changement de phase, par exemple par un procédé PVD.

Un autre avantage d'une cellule PCRAM confinée du type de celle illustrée en figure 3 est lié au fait que les pertes thermiques à la périphérie du via 41 sont réduites car la région périphérique 45 amorphe du via 41 est plus isolante thermiquement que le matériau isolant 37. La région 49 de la région centrale 43 du via 41 qui change de phase est moins épaisse que la région 23 dans le cas de la cellule PCRAM de la figure 2. Il en résulte une réduction de la consommation de la cellule PCRAM.

La figure 4 est une vue en coupe représentant de façon schématique une variante de la cellule PCRAM confinée de la figure 3. Les éléments communs avec ceux de la cellule PCRAM de la figure 3 sont désignés par les mêmes références.

Un via 51 en un matériau à changement de phase traverse la couche isolante 37 et s'étend de l'électrode supérieure 39 à l'électrode inférieure 33 (avantageusement revêtues de couches barrière 38, 34). Le via 51 en matériau à changement de phase comprend une région centrale 53 entourée par une région périphérique 55. Des espèces ont été implantées dans la région périphérique 55 du via 51 de sorte que les températures de cristallisation et de fusion de la région périphérique 55 soient supérieures à celles de la région centrale 53.

Comme pour la cellule PCRAM confinée illustrée en figure 3, la zone active de la cellule PCRAM confinée illustrée en figure 4 correspond à la région centrale 53 du via 51 en matériau à changement de phase, de diamètre d_{eff} inférieur au diamètre d du via 51.

La hauteur h du via 51 est par exemple comprise entre 30 et 100 nm, par exemple de l'ordre de 50 nm. Les dimensions latérales d du via 51 (le diamètre d du via 51 dans le cas où le via a une section circulaire) sont par exemple comprises entre 100 et 300 nm, par exemple de l'ordre de 150 nm. La région centrale 53 du via 51 a par exemple des dimensions latérales d_{eff} comprises entre 20 et 90 nm.

Selon un premier exemple de réalisation, le matériau à changement de phase 51 est en tellurure d'antimoine (Sb_{0,7}Te_{0,3}) et la région périphérique 55 du matériau 51 comprend du tellure (Te). Les températures de cristallisation et de fusion de la région centrale 53 en Sb_{0,7}Te_{0,3} sont respectivement d'environ 95°C et d'environ 550°C, tandis que les températures de cristallisation et de fusion de la région périphérique 55 ayant reçu une implantation de Te sont respectivement d'environ 150°C et d'environ 620°C.

Selon un second exemple de réalisation, le matériau à changement de phase 51 est en tellurure de germanium (Ge_{0,5}Te_{0,5}) et la région périphérique 55 du matériau 51 comprend du silicium (Si). Les températures de cristallisation et de fusion de la région centrale 53 en GeTe sont respectivement d'environ 180°C et d'environ 725°C, tandis que les températures de cristallisation et de fusion de la région périphérique 55 ayant reçu une implantation de Si sont respectivement d'environ 290°C et d'environ 885°C.

Comme pour la cellule PCRAM confinée de la figure 3, la région du matériau à changement de phase 51 qui passe de la phase cristalline à la phase amorphe et inversement, délimitée par des pointillés et désignée par la référence 59, est située sensiblement à égale distance des électrodes 33 et 39 et s'étend seulement sur la section de diamètre d_{eff} de la région centrale 53 du via 51. La région périphérique 55 du via 51 reste amorphe.

Le fonctionnement de cette cellule PCRAM confinée est similaire à celui de la cellule PCRAM confinée illustrée en figure 3.

On considère un état initial dans lequel la région centrale 53 du via 51 en matériau à changement de phase est cristalline (conductrice) et la région périphérique 55 du via 51 est amorphe (résistive).

Pour passer de cet état conducteur à un état résistif, une impulsion brève de tension élevée est appliquée entre les deux électrodes 33 et 39, de sorte que la région centrale 53 du via 51 atteigne sa température de fusion, mais pas la région périphérique 55 ayant reçu une implantation d'espèces qui a une température de fusion plus élevée. La région 59 de la région centrale 53 du via 51 fond puis se refroidit à l'état amorphe (résistif).

Pour passer de l'état résistif à l'état conducteur, une impulsion longue de tension faible est appliquée entre les deux électrodes 33 et 39, de sorte que la région centrale 53 du via 51 atteigne sa température de cristallisation, mais pas la région périphérique 55 ayant reçu une implantation d'espèces qui a une température de cristallisation plus élevée. La région 59 de la région centrale 53 du via 51 cristallise et redevient conductrice.

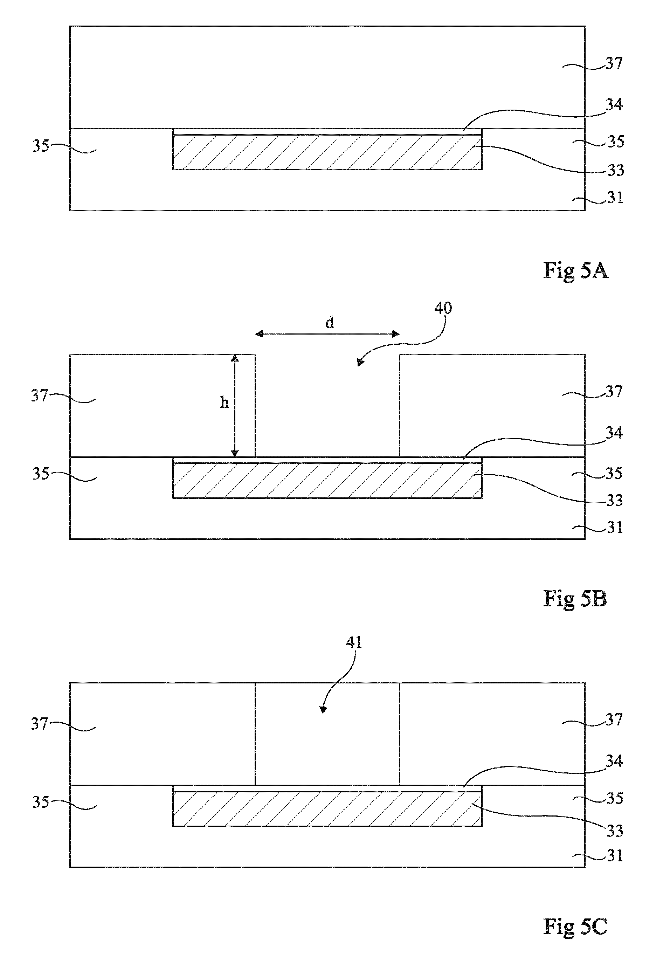

Les figures 5A à 5E sont des vues en coupe illustrant de façon schématique des étapes successives d'un procédé de fabrication d'une cellule PCRAM confinée du type de celle illustrée en figure 3.

La figure 5A représente la couche isolante 31 (reposant sur un substrat non représenté) revêtue de la couche conductrice 33, par exemple en AlSi, elle-même revêtue de la couche barrière 34, par exemple en TiN. Les couches 33 et 34 sont entourées du matériau isolant 35. La couche barrière 34 et le matériau isolant 35 sont recouverts de la couche isolante 37. La couche conductrice 33 constitue l'électrode inférieure de la cellule PCRAM en cours de formation.

En figure 5B, une ouverture 40, de diamètre d et de hauteur h, a été formée à partir de la surface supérieure de la couche isolante 37 jusqu'à la couche barrière 34.

En figure 5C, l'ouverture 40 a été remplie d'un matériau à changement de phase, par exemple en tellurure de germanium, pour former le via 41. Le matériau à changement de phase est par exemple déposé par un procédé PVD. Un polissage physico-chimique de type CMP ("Chemical Mechanical Polishing") est par exemple ensuite effectué, de sorte que la surface supérieure du via 41 en matériau à changement de phase affleure au même niveau que la surface supérieure de la couche isolante 37.

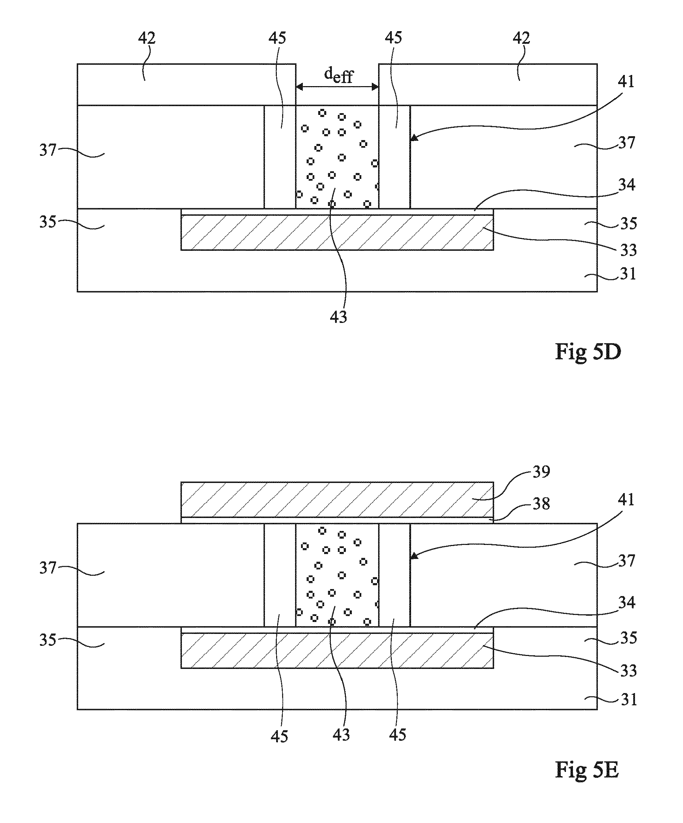

En figure 5D, des espèces ont été implantées dans une région centrale 43 de diamètre d_{eff} du via 41 en matériau à changement de phase. Pour cela, un masque 42 a été préalablement disposé au-dessus de la couche isolante 37 et au-dessus de la région périphérique 45 du via 41 dans laquelle on ne veut pas implanter d'espèces. Les espèces implantées sont par exemple de l'antimoniure d'étain ou de l'antimoine. Une fois les espèces implantées dans la région centrale 43, un recuit est effectué à une température inférieure à la température de cristallisation du matériau à changement de phase 41, de sorte que la région périphérique 45 reste amorphe.

En figure 5E, un empilement constitué de la couche barrière 38, par exemple en TiN, et de la couche conductrice 39, par exemple en AlSi, a été formé au-dessus du via 41 en matériau à changement de phase et au-dessus de portions de la couche isolante 37 entourant le via 41. La couche conductrice 39 constitue l'électrode supérieure de la cellule PCRAM confinée.

Pour former une cellule PCRAM confinée du type de celle illustrée en figure 4, à l'étape illustrée en figure 5D, des espèces sont implantées dans la région périphérique 55 du via 51, la région centrale 53 étant protégée par un masque. Une fois les espèces implantées dans la région périphérique 55, un recuit est effectué à une température inférieure à la température de cristallisation de la région périphérique 55, de sorte que cette région périphérique 55 reste amorphe.

Des modes de réalisation particuliers de la présente invention ont été décrits. Diverses variantes et modifications apparaîtront à l'homme de l'art. En particulier, tout matériau à changement de phase dont les températures de cristallisation et de fusion peuvent être modifiées de façon significative par implantation d'espèces peut être utilisé.

## Revendications

1. Cellule mémoire comprenant un via en un matériau à changement de phase (41, 51) disposé entre une électrode inférieure (33) et une électrode supérieure (39), dans laquelle le via comprend une région centrale (43, 53) entourée latéralement par une région périphérique (45, 55), chacune des régions centrale et périphérique s'étendant sur toute la hauteur du via, les températures de cristallisation et de fusion de la région centrale étant respectivement inférieures à celles de la région périphérique.

2. Cellule mémoire selon la revendication 1, dans laquelle le via en matériau à changement de phase (41, 51) a une hauteur (h) comprise entre 30 et 100 nm et des dimensions latérales (d) comprises entre 100 et 300 nm, et dans laquelle la région centrale (43, 53) du via a des dimensions latérales (d_{eff}) comprises entre 20 et 90 nm.

3. Cellule mémoire selon la revendication 1 ou 2, dans laquelle la région centrale (43) du via en matériau à changement de phase (41) comprend des espèces implantées.

4. Cellule mémoire selon la revendication 1 ou 2, dans laquelle la région périphérique (55) du via en matériau à changement de phase (51) comprend des espèces implantées.

5. Cellule mémoire selon la revendication 3, dans laquelle le matériau à changement de phase (41) est en tellurure de germanium et les espèces implantées sont de l'étain et de l'antimoine.

6. Cellule mémoire selon la revendication 4, dans laquelle le matériau à changement de phase (51) est en tellurure de germanium et les espèces implantées sont du silicium.

7. Cellule mémoire selon la revendication 4, dans laquelle le matériau à changement de phase (51) est en tellurure d'antimoine et les espèces implantées sont du tellure.

8. Cellule mémoire selon l'une quelconque des revendications 1 à 7, dans laquelle le via en matériau à changement de phase (41, 51) est entouré latéralement par un matériau isolant (37).

9. Cellule mémoire selon l'une quelconque des revendications 1 à 8, dans laquelle une première couche barrière (34) est interposée entre l'électrode inférieure (33) et le matériau à changement de phase (41, 51), et dans laquelle une seconde couche barrière (38) est interposée entre l'électrode supérieure (39) et le matériau à changement de phase.

10. Procédé de fabrication d'une cellule mémoire, comprenant les étapes suivantes :
former une ouverture (40) dans une couche isolante (37) recouvrant une première électrode (33) formée sur un substrat ;
remplir l'ouverture d'un matériau à changement de phase pour former un via (41) ;
implanter des espèces seulement dans une région centrale (43) du via en matériau à changement de phase pour que les températures de cristallisation et de fusion de cette région centrale soient inférieures respectivement à celles d'une région périphérique (45) du via entourant la région centrale ; et
recouvrir le via d'une seconde électrode (39).

11. Procédé de fabrication d'une cellule mémoire, comprenant les étapes suivantes :
former une ouverture (40) dans une couche isolante (37) recouvrant une première électrode (33) formée sur un substrat ;
remplir l'ouverture d'un matériau à changement de phase pour former un via (51) ;
implanter des espèces seulement dans une région périphérique (55) du via en matériau à changement de phase pour que les températures de cristallisation et de fusion de cette région périphérique soient supérieures respectivement à celles d'une région centrale (53) du via entourée par la région périphérique ; et
recouvrir le via d'une seconde électrode (39).

## Patentansprüche

1. Eine Speicherzelle, die eine Via hergestellt aus einem Fadenwechselmaterial (41, 51) aufweist, und zwar angeordnet zwischen einer unteren Elektrode (33) und einer oberen Elektrode (39), wobei die Via eine Mittelzone (43, 53) aufweist, seitlich umgeben von einer Umfangszone (45, 55), wobei sich jede der Mittel- und Umfangszonen über die gesamte Höhe der Via erstreckt; wobei die Kristallisations- und Schmelztemperaturen der Mittelzone entsprechend niedriger sind als diejenigen der Umfangszone.

2. Die Speicherzelle nach Anspruch 1, wobei die aus einem Phasenwechselmaterial (41, 51) hergestellte Via eine Höhe (h) besitzt im Bereich zwischen 30 und 100 nm und seitliche Abmessungen (d) im Bereich zwischen 100 und 300 nm, und wobei die Mittelzone (43, 53) der Via seitliche Dimensionen (d_{eff}) im Bereich zwischen 20 und 90 nm besitzt.

3. Die Speicherzelle nach Anspruch 1 oder 2, wobei die Mittelzone (43) der Via hergestellt aus Phasenwechselmaterial (41) implantierte Spezies aufweist.

4. Die Speicherzelle nach Anspruch 1 oder 2, wobei die Umfangszone (55) der Via hergestellt aus Phasenwechselmaterial (51) implantierte Spezies aufweist.

5. Die Speicherzelle nach Anspruch 3, wobei das Phasenwechselmaterial (41) aus Germaniumtellurid hergestellt ist und die implantierten Spezies Zinn und Antimon sind.

6. Die Speicherzelle nach Anspruch 4, wobei das Phasenwechselmaterial (51) aus Germaniumtellurid hergestellt ist und die implantierten Spezies Silizium sind.

7. Die Speicherzelle nach Anspruch 4, wobei das Phasenwechselmaterial (51) aus Antimontellurid hergestellt ist und die implantierten Spezies Tellur sind.

8. Die Speicherzelle nach einem der Ansprüche 1 bis 7, wobei die Via hergestellt aus Phasenwechselmaterial (41, 51) seitlich mit einem Isoliermaterial (37) umgeben ist.

9. Die Speicherzelle nach einem der Ansprüche 1 bis 8, wobei eine erste Barriereschicht (34) zwischen der unteren Elektrode (33) und dem Phasenwechselmaterial (41, 51) angeordnet ist, und wobei eine zweite Barriereschicht (38) zwischen der oberen Elektrode (39) und dem Phasenwechselmaterial angeordnet ist.

10. Ein Verfahren zur Herstellung einer Speicherzelle, wobei die folgenden Schritte vorgesehen sind:
Formen einer Öffnung (40) in einer Isolierschicht (37), die eine erste Elektrode (33), geformt auf einem Substrat abdeckt;
Füllen der Öffnung mit einem Phasenwechselmaterial um eine Via (41) zu bilden;
Implantieren von Spezies (Stoffen) in einer Mittelzone (43) der Via, hergestellt nur aus Phasenänderungsmaterial derart, dass die Kristallisationsund Schmelztemperaturen dieser Mittelzone jeweils niedriger sind als diese einer Umfangszone (45) der Via die die Mittelzone umgibt; und
Abdeckung der Via mit einer zweiten Elektrode (39).

11. Ein Verfahren zur Herstellung einer Speicherzelle, wobei die folgenden Schritte vorgesehen sind:
Formen einer Öffnung (40) in einer Isolierschicht (37), die eine erste Elektrode (33), geformt auf einem Substrat abdeckt;
Füllen der Öffnung mit einem Phasenwechselmaterial um eine Via (51) zu bilden;
Implantieren von Spezies (Stoffen) in einer Umfangszone (55) der Via, hergestellt nur aus Phasenwechselmaterial derart, dass die Kristallisationsund Schmelztemperaturen dieser Umfangszone entsprechend niedriger sind als diejenigen einer Mittelzone (53) der Via, umgeben von der Umfangszone; und
Abdecken der Via mit einer zweiten Elektrode (39).

## Claims

1. A memory cell comprising a via made of a phase-change material (41, 51) arranged between a lower electrode (33) and an upper electrode (39), wherein the via comprises a central region (43, 53) laterally surrounded with a peripheral region (45, 55), each of the central and peripheral regions extending over the whole height of the via; the crystallization and melting temperatures of the central region being respectively lower than those of the peripheral region.

2. The memory cell of claim 1, wherein the via made of a phase-change material (41, 51) has a height (h) ranging between 30 and 100 nm and lateral dimensions (d) ranging between 100 and 300 nm, and wherein the central region (43, 53) of the via has lateral dimensions (d_{eff}) ranging between 20 and 90 nm.

3. The memory cell of claim 1 or 2, wherein the central region (43) of the via made of phase-change material (41) comprises implanted species.

4. The memory cell of claim 1 or 2, wherein the peripheral region (55) of the via made of phase-change material (51) comprises implanted species.

5. The memory cell of claim 3, wherein the phase-change material (41) is germanium telluride and the implanted species are tin and antimony.

6. The memory cell of claim 4, wherein the phase-change material (51) is germanium telluride and the implanted species are silicon.

7. The memory cell of claim 4, wherein the phase-change material (51) is made of antimony telluride and the implanted species are tellurium.

8. The memory cell of any of claims 1 to 7, wherein the via made of phase-change material (41, 51) is laterally surrounded with an insulating material (37).

9. The memory cell of any of claims 1 to 8, wherein a first barrier layer (34) is interposed between the lower electrode (33) and the phase-change material (41, 51), and wherein a second barrier layer (38) is interposed between the upper electrode (39) and the phase-change material.

10. A method for manufacturing a memory cell, comprising the steps of:
forming an opening (40) in an insulating layer (37) covering a first electrode (33) formed on a substrate;
filling the opening with a phase-change material to form a via (41);
implanting species in a central region (43) of the via made of phase-change material only, so that the crystallization and melting temperatures of this central region are respectively lower than those of a peripheral region (45) of the via surrounding the central region; and
covering the via with a second electrode (39).

11. A method for manufacturing a memory cell, comprising the steps of:
forming an opening (40) in an insulating layer (37) covering a first electrode (33) formed on a substrate;
filling the opening with a phase-change material to form a via (51);
implanting species in a peripheral region (55) of the via made of phase-change material only, so that the crystallization and melting temperatures of this peripheral region are respectively lower than those of a central region (53) of the via surrounded with the peripheral region; and
covering the via with a second electrode (39).
